# EUROPEAN PATENT APPLICATION

(11) **EP 1 939 928 A1**
(43) Date of publication of application: **02.07.2008**
(21) Application number: 06812020.3
(22) Date of filing: 19.10.2006
(51) Int. Cl.: H01L 21/205, H01L 21/318

(54) **NITRIDE SEMICONDUCTOR DEVICE AND METHOD FOR MANUFACTURING SAME**

(30) Priority: 20.10.2005 JP 2005305596
(71) Applicant: ROHM CO., LTD., Kyoto-shi, Kyoto 615-8585 (JP)
(72) Inventor: SHAKUDA, Yukio, Kyoto-shi, Kyoto 6158585 (JP); SONOBE, Masayuki, Kyoto-shi, Kyoto 6158585 (JP); ITO, Norikazu, Kyoto-shi, Kyoto 6158585 (JP)
(74) Representative: TBK-Patent
(86) International application number: PCT/JP2006/320842
(87) International publication number: WO 2007/046465

(57) **Abstract**

There is provided a nitride semiconductor device with low leakage current and high efficiency in which, while a zinc oxide based compound such as MgₓZn₁₋ₓO (0 ≦ x ≦ 0.5) is used for a substrate, crystallinity of nitride semiconductor grown thereon is improved and film separation or cracks are prevented. The nitride semiconductor device is formed by laminating nitride semiconductor layers on a substrate (1) made of a zinc oxide based compound such as MgₓZn₁₋ₓO (0 ≦ x ≦ 0.5). The nitride semiconductor layers include a first nitride semiconductor layer (2) made of Al_{y}Ga_{1-y}N (0.05 ≦ y ≦ 0.2) which is provided in contact with the substrate (1), and nitride semiconductor layers (3) to (5) laminated on the first nitride semiconductor layer (2) so as to form a semiconductor element.

## Description

### FIELD OF THE INVENTION

The present invention relates to a semiconductor device using nitride semiconductor crystal layers, such as a light emitting device like a light emitting diode (LED), a laser diode (LD) or the like, or a transistor device like a HEMT or the like, using nitride semiconductor, and a method for manufacturing the same. More particularly, the present invention relates to a nitride semiconductor device capable of growing nitride semiconductor layers with excellent crystallinity by preventing a surface of a substrate from being roughened by etching the substrate with a raw material of group V element for forming the nitride semiconductor layers, while using a MOCVD (metal organic chemical vapor deposition) method which makes mass production easy, and a method for manufacturing the same.

### BACKGROUND OF THE INVENTION

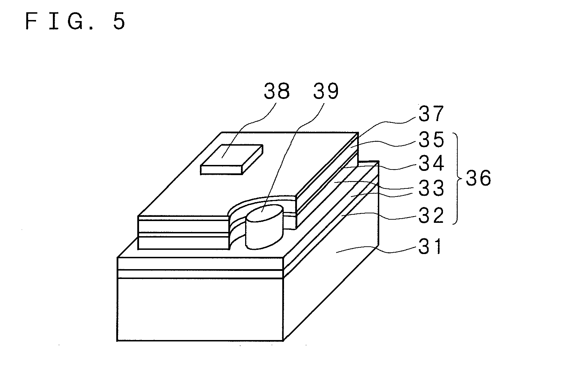

In recent years, nitride semiconductor light emitting devices such as a blue light emitting diode (LED) or a laser diode, using nitride semiconductor, have been in practical use. As shown, for example, in Fig. 5, the LED emitting blue light using nitride semiconductor is provided with: a semiconductor lamination portion 36 formed by laminating, on a sapphire substrate 31 by a MOCVD method, a low temperature buffer layer 32 made of GaN or the like, an n-type layer 33 made of GaN or the like, an active layer (light emitting layer) 34 made of, for example, InGaN based (which means that a ratio of In to Ga can be varied variously and the same applies hereinafter) compound semiconductor which has a smaller band gap energy than that of the n-type layer 33 and decides a wavelength of emitted light, and a p-type layer 35 made of GaN or the like; a p-side electrode 38 provided on a surface thereof interposing a light transmitting conductive layer 37; and an n-side electrode 39 provided on a surface of the n-type layer 33 exposed by etching a part of the semiconductor lamination portion 36. In addition, a semiconductor layer having still larger band gap energy such as an AlGaN based (which means that a ratio of Al to Ga can be varied variously and the same applies hereinafter) compound or the like may be used on the active layer side of the n-type layer 33 and the p-type layer 35 in order to increase an effect of carrier confinement (cf. for example PATENT DOCUMENT 1).
PATENT DOCUMENT 1: Japanese Patent Application Laid-Open No. HEI10-173222 (cf. Fig. 1)

### DISCLOSURE OF THE INVENTION

### PROBLEM TO BE SOLVED BY THE PRESENT INVENTION

In case of growing a nitride semiconductor layer, a sapphire substrate is mostly used as described above, however, since lattice constants of the sapphire substrate and a nitride semiconductor material are very different, a semiconductor device with high quality can be hardly obtained. Then, in recent years, a structure using a ZnO substrate having a lattice constant similar to that of the nitride semiconductor material has been suggested in place of the sapphire substrate.

But, when it is intended to use a ZnO substrate and grow a nitride semiconductor layer thereon by using a MOCVD apparatus, the nitride semiconductor layer is usually grown at a high temperature of, concretely, at least 600 °C or more by using an organic metal compound for a raw material of group III element and ammonia gas for a raw material of group V element. However, the ammonia gas has a function of etching a surface of the ZnO substrate under a high temperature condition, therefore, the surface of the ZnO substrate is roughened by the ammonia gas just before growing the nitride semiconductor layer on the ZnO substrate, and there occasionally occurs deterioration of crystallinity of the nitride semiconductor layer grown thereon, or film separation between the nitride semiconductor layer and the substrate. On the other hand in order to inhibit the above described problem, there is nothing but growing the nitride semiconductor layer at an extremely low temperature of, concretely, 600 °C or less for preventing the surface from being roughened, however, even if the nitride semiconductor layer is formed at the low temperature, the crystallinity of the nitride semiconductor layer deteriorates, an electric resistance of a film grown becomes high, and, as a result, the nitride semiconductor layer can not be used practically. As mentioned above, if the nitride semiconductor layer is grown on the ZnO substrate by a MOCVD method, a nitride semiconductor layer with excellent quality can not be obtained in both cases of a high and low temperatures.

In addition, even if a GaN or an InGaN based compound is grown directly on the ZnO substrate as the nitride semiconductor layer, since difference between coefficients of thermal expansion of the ZnO substrate and the GaN or the InGaN based compound is too large, cracks occur in the grown layers made of the GaN or the InGaN based compound, leakage current arises, or the like, therefore, there arise problems such as deterioration of light emitting efficiency and leakage current.

The present invention is directed to solve the above-described problems and an object of the present invention is to provide a nitride semiconductor device with low leakage current and high characteristics in which, while a zinc oxide based compound such as MgₓZn₁₋ₓO (0 ≦ x ≦ 0.5) is used for a substrate, crystallinity of nitride semiconductor grown thereon is improved and film separation or cracks are prevented.

Another object of the present invention is to provide a method for manufacturing a nitride semiconductor device with excellent characteristics by growing nitride semiconductor layers with excellent crystallinity, by using a zinc oxide based compound such as MgₓZn₁₋ₓO (0≦x≦0.5) as a substrate, and preventing a surface of the MgₓZn₁₋ₓO substrate from being etched by ammonia gas when the nitride semiconductor layers are grown epitaxially by using a MOCVD method.

Still another object of the present invention is to provide a semiconductor light emitting device such as a LED, a semiconductor laser or the like having a structure capable of improving light emitting characteristics such as external quantum efficiency by using such nitride semiconductor, and a method for manufacturing the same.

### MEANS FOR SOLVING THE PROBLEM

The present inventors found a method capable of growing nitride semiconductor with excellent crystallinity even by a MOCVD method while using a zinc oxide based (also referred to as ZnO based) compound such as MgₓZn₁₋ₓO (0 ≦ x ≦ 0.5), in which temperature is raised to not so high temperature of 600 to 800 °C at the time of growing a first semiconductor layer, a molar ratio ((group V element)/(group III element)) of a raw material of group V element to that of group III element is set to 2,000 or less, which is much smaller than 8,000 to 10,000 in usual cases for forming the nitride semiconductor layers, and, an exposed portion of the zinc oxide based compound substrate is covered by growing an AlGaN based compound layer firstly, thereby, the substrate is not roughened by invasion of ammonia gas of the raw material of group V element during growth of nitride semiconductor layers by usual MOCVD method thereafter, and nitride semiconductor layers with complete crystals can be grown.

Namely, since a zinc oxide based compound substrate is etched by ammonia gas of a raw material of group V element in accordance of raising a growth temperature at a high temperature of 600 °C or more in which a nitride semiconductor layer with excellent crystallinity can be obtained in a MOCVD method, the substrate is roughened before growing the nitride semiconductor and the nitride semiconductor layer with excellent crystallinity can not be grown. On the other hand, the nitride semiconductor layer with excellent crystallinity can not be grown even if it is grown at a low temperature of 600 °C or less.

However, it was found that if the first nitride semiconductor layer is grown, first of all, at a temperature range of 600 °C or more in which crystallinity of nitride semiconductor layers does not deteriorate extremely and 800 °C or less in which etching of a ZnO substrate by ammonia hardly advances, and by lowering a molar ratio of ammonia of a raw material of group V element to a raw material of group III element, etching of a surface of the zinc oxide based compound substrate by ammonia gas is remarkably suppressed. In addition, it was also found that, by using an AlGaN based compound in which Al concentration is not large, as the first nitride semiconductor layer, in place of GaN or an InGaN based compound, it is inhibited by existence of Al that film separation is caused by difference of coefficient of thermal expansion with the substrate, and that ammonia reaches and etches the substrate, thereafter nitride semiconductor layers with excellent crystallinity can be grown on the first nitride semiconductor layer even by using usual growing method. More concretely, if GaN or InGaN based compound is used for the first nitride semiconductor layer contacted with the substrate, ammonia gas occasionally transmits the layer made of GaN or an InGaN based compound since In is apt to evaporate, and roughens a surface of the ZnO substrate thereunder. However, if AlGaN based compound is used for the first nitride semiconductor layer, since Al is contained in the first nitride semiconductor layer, invasion of ammonia gas to a surface of the substrate can be prevented by existence of Al, furthermore, since the layer made of AlGaN based compound has a strong film adhesion strength comparing with a layer made of GaN or InGaN based compound, film separation hardly occurs. Then, once a layer made of AlGaN based compound, with a composition with a certain Al ratio or more, and thickness of a certain thickness, is formed for the first nitride semiconductor layer, film separation does not occur, and even at the time of laminating a second nitride semiconductor layers thereafter under a high temperature condition, it was found that since ammonia gas does not reach the surface of the substrate, the nitride semiconductor layer with excellent crystallinity can be grown on the first nitride semiconductor layer even by using usual growth method.

After further earnest and repeated study for preventing a surface of the ZnO substrate from being roughened, the present inventors found that conditions of roughness of the surface caused by ammonia are different depending on conditions of a principal plane of the ZnO substrate. Namely, it is found that there are an O-polarity plane and a Zn-polarity plane when a C plane is used as a principal plane of the ZnO substrate, however, in case of a principal plane of the Zn-polarity plane, since Zn exists on the surface, resistance to etching is strong to ammonia gas comparing with a case such that O exists on the surface, and the surface is less roughened by ammonia comparing with a case of the O-polarity plane.

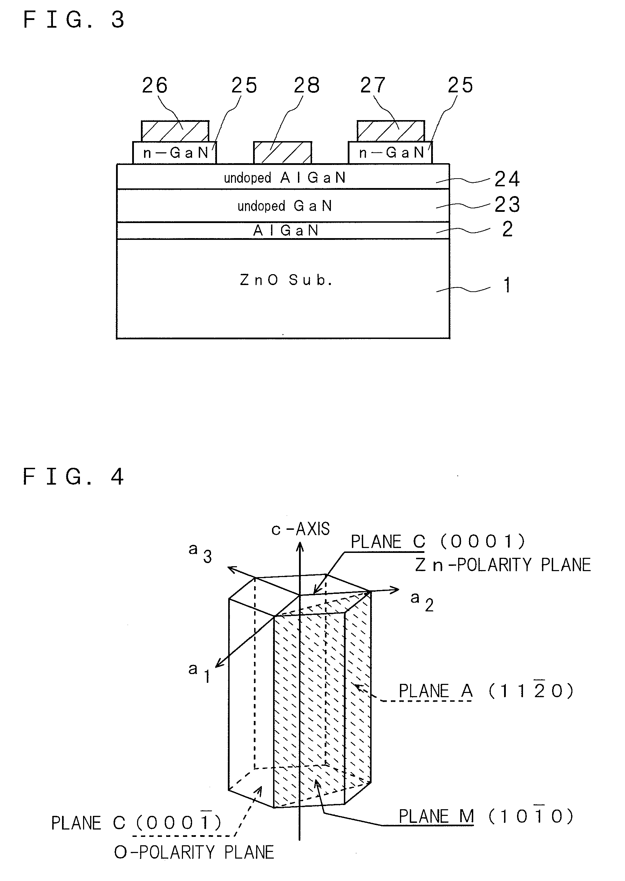

Here, the zinc oxide (ZnO) based compound semiconductor means an oxide including Zn, and means concretely besides ZnO, an oxide of one or more elements of group IIA and Zn, an oxide of one or more elements of group IIB and Zn, or an oxide of elements of group IIA and group II B and Zn. And, the nitride semiconductor means a compound of Ga of group III element and N of group V element or a compound (nitride) in which a part or all of Ga of group III element substituted by other element of group III element like Al, In or the like and/or a part of N of group V element substituted by other element of group V element like P, As or the like. In addition, a zinc oxide based compound, for example MgₓZn₁₋ₓO, has a hexagonal crystal structure as its schematic perspective view is shown in Fig. 4, a C plane is a (0001) plane of a Zn-polarity plane or a (000-1) plane of an O-polarity plane, as shown in Fig. 4, and any of them is a plane orthogonal to an A plane {11-20} and the M plane {10-10}. In addition, (000-1), (11-20), (10-10), {11-20} and {10-10} mean strictly, respectively

(0001̅), (112̅0), (101̅0), {112̅0} and {101̅0},

however, an abbreviated notation is used as described above in convenience. In addition, for example, a {11-20} plane means a general term meaning including planes equivalent to a (11-20) plane by symmetricity of crystals.

A nitride semiconductor device according to the present invention includes a substrate made of zinc oxide based compound and nitride semiconductor layers laminated on the substrate, wherein the nitride semiconductor layers comprise a first nitride semiconductor layer made of Al_{y}Ga_{1-y}N (0.05 ≦ y ≦ 0.2) provided in contact with the substrate, and nitride semiconductor layers laminated on the first nitride semiconductor layer so as to form a semiconductor element.

It is preferable that a thickness of the first nitride semiconductor layer is 500 Angstroms or more since ammonia gas can be sufficiently prevented from transmitting the first nitride semiconductor layer and reaching the substrate, and the surface of the zinc oxide based compound substrate can be sufficiently prevented from being roughened. Further, it is preferable that a principal plane of the substrate is a (0001) Zn polarity plane since the surface of the ZnO substrate can be more sufficiently prevented from being roughened as described above.

Concretely, an n-type layer, an active layer and a p-type layer are laminated on the first nitride semiconductor layer so as to form a light emitting layer, thereby a semiconductor light emitting device can be formed.

A method for manufacturing a nitride semiconductor device according to the present invention includes the steps of: setting a substrate made of a zinc oxide based compound within a MOCVD apparatus; growing a first nitride semiconductor layer made of Al_{y}Ga_{1-y}N (0.05≦y≦0.2) at a low temperature of 600 to 800 °C which is lower than that for growing a GaN crystal layer, by supplying raw materials of group III element and group V element with a molar ratio of a raw material of group V element to that of group III element ((group V element)/ (group III element)) of 500 or more and 2,000 or less; and growing desired semiconductor layers subsequently. Here, a molar ratio of a raw material of group V element to that of group III element means, in a gas flowing into a growth chamber of the MOCVD apparatus in a predetermined period (for example 1 minute), a value obtained by dividing a molar quantity of the gas (ammonia, arsine, phosphine or the like) containing a group V element of a raw material of N, P and As composing nitride semiconductor and being taken in a film after decomposition, by a molar quantity of the gas (TMG, TMA and TMIn) containing a group III element of a raw material of Ga, Al, In or the like composing the nitride semiconductor and being taken in a film after decomposition. In addition, N₂ gas is regarded as not to be included in group V element since N₂ does not decompose although N₂ gas contains N.

In addition, it is preferable that the step of growing the first nitride semiconductor layer is performed by firstly supplying the raw material of group III element, and thereafter supplying the raw material of group V element, because the group III element is deposited on a surface of a zinc oxide based compound substrate like in a monolayer by supplying the group III element, the film capable of inhibiting etching by ammonia gas can be formed, and etching by ammonia gas can be inhibited more.

### EFFECT OF THE INVENTION

In the nitride semiconductor device according to the present invention, nitride semiconductor layers are laminated on a substrate made of a zinc oxide based compound such as MgₓZn₁₋ₓO or the like, and the first nitride semiconductor layer made with the Al_{y}Ga_{1-y}N (0.05≦y≦0.2) layer which has a comparatively low Al concentration, a coefficient of thermal expansion of which is similar to that of the ZnO substrate, is provided in contact with the substrate, thereby, a problem of lattice mismatching does not arise and a surface of the substrate is prevented from being roughened by ammonia gas by a function of Al. And the coefficient of thermal expansion of the AlGaN based compound is small comparing to that of GaN or an InGaN based compound and similar to that of the ZnO based compound, therefore, there can be inhibited cracks caused by difference of the coefficient of thermal expansion which are generated when the nitride semiconductor layers made of GaN or the InGaN based compound laminated thereon is formed directly on the substrate. Then, nitride semiconductor layers with excellent crystallinity can be grown and a nitride semiconductor device with high performance such as a nitride semiconductor light emitting device or the like with high light emitting characteristics can be obtained. In addition, by using a (0001) plane of the Zn-polarity plane as a principal plane of the substrate, a surface of the zinc oxide based compound substrate can be more prevented from being roughened by ammonia, and nitride semiconductor layers with higher quality can be formed.

By the method for manufacturing a nitride semiconductor device according to the present invention, since the first semiconductor layer made of Al_{y}Ga_{1-y}N is grown on the substrate made of a zinc oxide based compound such as MgₓZn₁₋ₓO or the like by raising a growth temperature to a comparatively low temperature of 600 to 800 °C, and lowering the ammonia concentration up to the most so as to lower a molar ratio of the raw material of group V element to that of group III element to 2,000 or less in place of 10,000 in usual cases, even if the nitride semiconductor layers are grown by a MOCVD method, the substrate is not roughened and the nitride semiconductor layers with very complete crystals can be grown. In addition, if a ratio of the raw material of group V element is lowered too much, crystallinity of the nitride semiconductor layers is deteriorated, however, deterioration of the crystallinity can be prevented by setting the ratio to 500 or more.

As a result, even when a LED, a laser diode (LD) or the like is formed, the semiconductor light emitting device with excellent characteristics having a low operation current, high internal quantum efficiency, and a low threshold current can be obtained, and when a transistor or the like is formed, a transistor (HEMT) with a high speed having a small leakage current and a high withstand voltage can be obtained.

### BRIEF DESCRIPTION OF THE DRAWINGS

Fig. 1 is an explanatory cross-sectional view of a LED which is an embodiment of the nitride semiconductor device according to the present invention.
Fig. 2 is an explanatory cross-sectional view of an example which is another structure of the nitride semiconductor device according to the present invention.
Fig. 3 is an explanatory cross-sectional view of a constitution of the transistor formed by the present invention.
Fig. 4 is a figure for explaining a ZnO crystal structure.
Fig. 5 is a figure of an example of a constitution of a LED using conventional nitride semiconductor.

### EXPLANATION OF LTTERS AND NUMERALS

1: substrate
2: first nitride semiconductor layer
3: n-type layer
4: active layer
5: p-type layer
6: semiconductor lamination portion
7: light transmitting conductive layer
8: p-side electrode
9: n-side electrode

### THE BEST EMBODIMENT OF THE PRESENT INVENTION

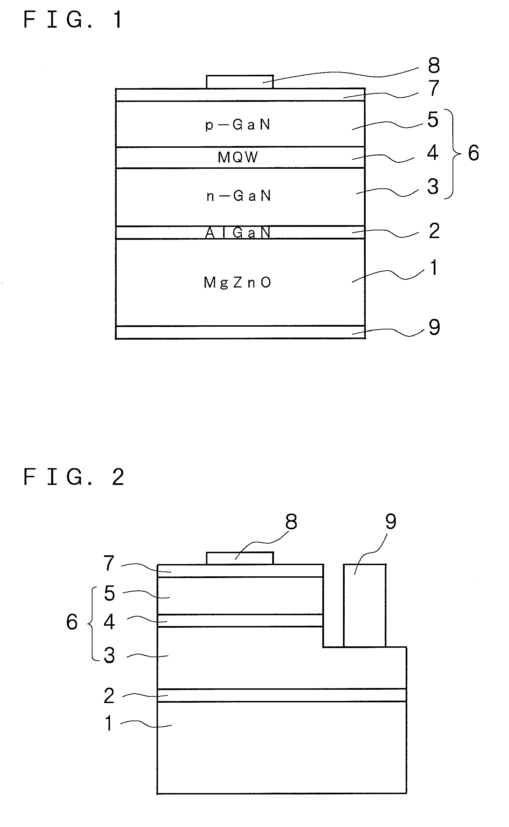

An explanation will be given below of a nitride semiconductor device and a method for manufacturing the same, according to the present invention in reference to the drawings. As an explanatory cross-sectional view of a nitride semiconductor light emitting device (LED chip) of an embodiment is shown in Fig. 1, the nitride semiconductor device according to the present invention is formed by laminating nitride semiconductor layers on a substrate 1 made of a zinc oxide based compound such as MgₓZn₁₋ₓO (0 ≦ x ≦ 0.5). The nitride semiconductor layers include a first nitride semiconductor layer 2 made of Al_{y}Ga_{1-y}N (0.05 ≦ y ≦ 0.2) which is provided in contact with the substrate 1, and nitride semiconductor layers 3 to 5 laminated on the first nitride semiconductor layer 2 so as to form a semiconductor element (so as to form a light emitting layer of the LED in the example shown in Fig. 1).

Namely, the present invention is characterized in using a substrate made of a zinc oxide based compound such as MgₓZn₁₋ₓO or the like as the substrate 1, and providing an Al_{y}Ga_{1-y}N layer on a surface of the substrate as the first nitride semiconductor layer 2, in order to laminate nitride semiconductor layers by a MOCVD method. As described above, when the nitride semiconductor layers are grown by the MOCVD method, growing is usually carried out at a temperature of 800 °C or more because high quality of a GaN film can be obtained at a high growth temperature, however the zinc oxide based compound substrate is etched by ammonia gas, a surface of the substrate where epitaxial growth is carried out is roughened, and nitride semiconductor layers with high quality of a film can not be grown. On the other hand, when the growing is carried out at a low temperature of 600 °C or less in order to prevent the above-described problem, quality of a film of GaN deteriorates, and there arise problems such as deterioration of crystallinity of the nitride semiconductor layers, lowering of light emitting efficiency caused by increase of leakage current, and increase of the leakage current.

However, the present inventors found, as a result of earnest and repeated studies as described above, that by growing the AlGaN layer containing Al which has a function of inhibiting etching by ammonia gas, and having a comparatively low Al concentration in which lattice mismatching hardly occurs, at a temperature of 600 to 800 °C and at a molar ratio of the raw material of group V element to that of group III element of 2,000 or less, the substrate made of the ZnO based compound is not roughened and nitride semiconductor layers with excellent crystallinity can be grown.

As the substrate 1, a zinc oxide based compound such as MgₓZn₁₋ₓO or the like, for example a ZnO substrate 1, is used. By using such oxide, the substrate can be easily removed by wet etching, and one electrode can be taken out from a back surface of the substrate since semiconductor has conductivity, and lattice matching can be easily achieved because a lattice constant thereof is similar to that of the nitride semiconductor layer above all, thereby, a film can be formed with higher quality than that in a conventional case using a sapphire substrate. In case of forming a light emitting device emitting light with a short wavelength, the substrate 1 may be made of MgₓZn₁₋ₓO or the like in which Mg is mixed so as not to absorb the light, in place of being made of ZnO. However, it is not preferable that a concentration of Mg is over 50 at% since MgO is a crystal of a NaCl type which does not match with a ZnO based compound of a hexagonal system in lattice. In addition, the MgₓZn₁₋ₓO substrate is formed by cutting out wafers from an ingot formed by a hydrothermal synthesis method or the like.

In addition, it is preferable to use the Zn-polarity plane (0001) shown in Fig. 4 as a principal plane of the substrate 1 as described above, because, comparing with a principal plane of the O-polarity plane, resistance to ammonia gas is strong, and a ZnO surface is less roughened, however, other planes may be used.

As described above, since a surface of the substrate 1 is etched by ammonia gas when being exposed to an ammonia atmosphere under a high temperature, the surface is roughened, crystallinity of the substrate itself deteriorates, and, at the same time, crystallinity of nitride semiconductor layers grown thereon deteriorates remarkably. Then, the nitride semiconductor layers are preferably formed by protecting a back surface, side and an end portion of the surface of, for example, the ZnO substrate 1 by coating with a protection film made of SiO, SiN or Pt which does not evaporate at a high temperature of 600 °C or more, and setting the ZnO substrate (wafer) on a work carrier of the MOCVD apparatus, made of carbon, molybdenum or the like.

The first nitride semiconductor layer 2 is made of the AlGaN based compound and formed by a usual MOCVD method at a low temperature of 600 to 800 °C which is lower than a usual growth temperature of a GaN crystal layer, and with setting a molar ratio of the raw material of group V element to that of group III element to 500 or more and 2,000 or less. Namely, as described above, when the nitride semiconductor layer is formed by using the ZnO substrate 1, and by the MOCVD method at a high temperature of 600 °C or more for growing the nitride semiconductor layer, the ZnO substrate 1 is etched by ammonia gas, the surface thereof is roughened, and the nitride semiconductor layer with excellent crystallinity can not be grown. However, it is found that, even if a temperature is 600 °C or more, activity and absolute quantity of ammonia gas is lowered and the substrate can be prevented from being etched by growing in a range of the temperature up to 800 °C, and by lowering a molar ratio of the raw material of group V element to that of group III element to 2,000 or less in place of 10,000 of usual cases. In addition, as described above, since the AlGaN based compound contains Al, once it is grown, it has a feature such that ammonia gas does not transmit the first nitride semiconductor layer 2, etching of a surface of the substrate and film separation can be prevented. Moreover, since difference of a coefficient of thermal expansion of the AlGaN based compound and the substrate is smaller than that of GaN or InGaN based compound, leakage current caused by occurrence of cracks does not arise. Thus, by forming a nitride semiconductor layer made of the AlGaN based compound at a temperature of 600 to 800 °C, and with setting a molar ratio of the raw material of group V element to that of group III element to 2,000 or less, the ZnO substrate 1 can not be roughened and the nitride semiconductor layers with excellent crystallinity can be grown.

More concretely, by setting an Al composition to 20% or less, lattice matching between the nitride semiconductor layers 3 to 5 grown on the substrate 1 and the first nitride semiconductor layer 2 can be achieved up to the most, thereby, crystallinity is improved. In addition, as described above, in order to prevent ammonia gas from transmitting the first nitride semiconductor layer 2 and etching a surface of the substrate, the Al composition is set to 5% or more at least. And, a thickness of the first nitride semiconductor layer 2 is set to 500 Angstroms or more, more preferably 2,000 to 8,000 Angstroms, in order to prevent the ammonia gas from transmitting the first nitride semiconductor layer 2 perfectly. In addition, in case of forming one electrode on a back surface of the substrate 1, a conductivity type of the first nitride semiconductor layer 2 is required to be the same conductivity type as the substrate 1, however, in case of not forming an electrode on the back surface of the substrate 1, the first nitride semiconductor layer 2 may be formed undoped or doped with Si (n dopant) or the like.

In addition, it is not always necessary that the first nitride semiconductor layer 2 contains a constant quantity of Al in any place of the layer, and the concentration may be varied to make it easy to achieve lattice matching corresponding to an n-type layer 3 laminated on the first nitride semiconductor layer 2. The variation of the concentration may be stepwise or continuous. For example, if the n-type layer 3 is made of GaN, it is more preferable that, the concentration is brought to that of the n-type layer 3 by decreasing an Al concentration of AlGaN of the first nitride semiconductor layer with approaching to a surface side. In addition, between the first nitride semiconductor layer 2 and the n-type contact layer 3, a super lattice structure or a gradient layer may be provided to cancel a lattice mismatching caused by difference therebetween.

Other semiconductor lamination portion 6 in an example shown in Fig. 1 is formed by providing the n-type layer 3 made of n-type GaN doped with Si having a thickness of approximately 1 to 10 µm, an active layer 4 made with a MQW structure (multiple quantum well structure formed by laminating 3 to 8 pairs of well layers made of, for example, In_{0.17}Ga_{0.83}N and having a thickness of 1 to 3 nm, and barrier layers made of In_{0.01}Ga_{0.99}N and having a thickness of 10 to 20 nm) of an undoped InGaN based compound and GaN, having a thickness of approximately 0.05 to 0.3 µm in total, and a p-type layer 5 made of GaN doped with Mg having a thickness of approximately 0.2 to 1µm.

In addition, the semiconductor lamination portion 6 is laminated with a necessary constitution depending on a semiconductor device manufactured, then, also in case of a LED, not being limited to the above-described example, the n-type layer 3 and the p-type layer 5 may be formed in a multi-layer structure provided with a layer (barrier layer) having a large band gap energy at the active layer side, or a super lattice structure or a gradient layer may be provided between semiconductor layers having different compositions. In addition, a structure of the active layer 4 may be a bulk structure or a single quantum well (SQW) structure, not limited to the multi quantum well structure. Further, although the example shows a double hetero junction structure formed by holding the active layer 4 with the n-type layer 3 and the p-type layer 5, a hetero junction structure formed by joining an n-type layer and a p-type layer directly may be used. The point is that the n-type layer 3 and the p-type layer 5 are provided so as to form a light emitting layer in case of constituting a LED. In addition, although the above-described example is an example of a LED, a laser diode can be formed similarly by forming a light emitting region having a stripe shape.

Subsequently, an explanation of a method for manufacturing the nitride semiconductor light emitting device shown in Fig. 1 will be given below. A wafer, in which a protection film is provided on a region except a growth surface of the ZnO substrate 1 formed with, for example, an n-type conductivity, and with a principal plane of the (0001) Zn-polarity plane, is set within the MOCVD apparatus, and the surface of the substrate is cleaned in an hydrogen carrier gas at a raised temperature of 600 to 800 °C , for example 700 °C . Subsequently, by supplying ammonia gas (NH₃) of the raw gas of group V element, and trimethyl gallium (TMG) and trimethyl aluminium (TMA) of group III element, the first nitride semiconductor layer 2 made of Al_{y}Ga_{1-y}N (0.05≦y≦0.2, for example y=0.2) is grown with Si doping and with a thickness of 500 Angstroms or more, for example approximately 4,000 Angstroms. Here, flow rates of the ammonia gas and the carrier gas carrying the raw material of group III element are adjusted so as to set a molar ratio of the raw materials of group V element and group III element to 2,000 or less, for example approximately 500 (the raw material of group V element of 2×10⁻² and the raw material of group III element of 4×10⁻⁵). Although the Si doping is necessary for forming an electrode on a back surface of the substrate 1, an undoped substrate may be used in case of not forming an electrode on a back surface of the substrate. It is preferable for preventing the surface of the ZnO substrate from being roughened that an atmosphere within a chamber is made with an atmosphere of a raw material of group III element at first by supplying TMA and TMG of an organic metal of a raw material of group III element for several seconds just before growing the first nitride semiconductor layer 2, thereby the protection film is formed on the surface of the ZnO substrate with the raw material of group III element, thereafter, ammonia of the raw material of group V element is supplied.

Thus, the first nitride semiconductor layer 2 is grown at a temperature of 600 to 800 °C and made of an AlGaN based compound satisfying a condition such that a molar ratio of group V element and group III element is 2,000 or less, thereby, as described above, ammonia gas never roughens a surface of the ZnO substrate 1 and nitride semiconductor layers with excellent crystallinity can be grown.

Thereafter, a temperature of the substrate is raised to a high temperature of approximately 800 to 1,200 °C, for example 1,000 °C, and the n-type layer 3 made of GaN doped with Si is grown with a thickness of approximately 1 to 10 µm. In addition, after growing the n-type layer, the temperature of the substrate is lowered to 600 to 800 °C, then a super lattice layer or the like made of an InGaN based compound and GaN may be grown by doping with Si. Here, the super lattice layer is preferably provided to preventing a lattice strain from being applied to the active layer which especially requires excellent crystallinity. Thereafter, there is laminated the active layer 4 which is made with MQW formed by laminating 3 to 8 pairs of, for example, well layers made of In_{0.17}Ga_{0.83}N and having a thickness of 1 to 3 nm, and barrier layers made of GaN and having a thickness of 10 to 20 nm. In addition, the active layer 4 is made with not only MQW but also SQW or a bulk structure made of InGaN. Subsequently, a temperature within the growth apparatus is raised to approximately 800 to 1,200 °C, for example 1,000 °C, the p-type layer 5 made of GaN doped with Mg and having a thickness of approximately 0.2 to 1 µm is grown, thereby the semiconductor lamination portion 6 is formed.

In addition, in the above-described case of growing each semiconductor layer after the n-type layer 3, the semiconductor layer with a desired composition, a desired conductivity type and a desired thickness can be formed by supplying, together with H₂ of a carrier gas, necessary gasses such as a reaction gas such as trimethyl gallium (TMG), ammonia (NH₃), trimethyl aluminium (TMA), trimethyl indium (TMIn), an n-type dopant gas such as SiH₄, a p-type dopant gas such as biscyclopentadienyl magnesium (Cp₂Mg), or the like. In addition, when a concentration of In or Al of an InGaN based compound and an AlGaN based compound is changed, it can be changed by adjusting a flow rate of TMIn of a raw material gas of In or TMA of a raw material gas of Al.

Thereafter, a light transmitting conductive layer 7, having a thickness of approximately 0.01 to 5 µm, which is made of, for example, ZnO or the like and capable of ohmic contact with the p-type semiconductor layer 5 is provided on a surface of the semiconductor lamination portion 6. The ZnO is formed in a film so as to have a specific resistance of approximately (3 to 5) ×10⁻⁴ Ω · cm by doping Ga. The light transmitting conductive layer 7 is not limited to ZnO, and a thin alloy film of ITO or Ni and Au having a thickness of 2 to 100 nm can diffuse electric current to whole of a chip while transmitting light.

Then, after polishing a back surface of the substrate 1 so that a thickness of the substrate 1 is approximately 100 µm, an n-side electrode 9 is formed by laminating Ti/Au or Cr/Pt/Au or the like on the back surface, further a p-side electrode 8 is formed with a lamination structure made of Ti/Au by a lift off method on a surface of the light transmitting conductive layer 7, and whole of a chip is covered with a SiON film not shown in the figure by a plasma CVD method and an opening portion is formed at an electrode portion. Thereafter, a light emitting device chip having a structure shown in Fig. 1 is formed by dividing a wafer into chips. In addition, when the wafer is divided into the chips, border portions of the chips of the semiconductor lamination portions are previously etched in a mesa shape by dry etching. The n-side electrode 9 may be formed on a surface of the n-type layer 3 exposed by etching a part of the semiconductor lamination portion 6 instead of forming on the back surface of the substrate 1, as described later.

According to the present invention, since nitride semiconductor layers are laminated on the ZnO based compound substrate, one electrode can be formed on a back surface of the substrate, and a device of a vertical type can be formed in which a pair of electrodes is formed at an upper and lower surfaces of a chip. However, even in case of using such substrate, the n-side electrode can be formed on the n-type layer 3 exposed by etching a part of the semiconductor lamination portion 6 laminated, by dry etching, as shown in Fig. 2. By using such structure, a device emitting sufficient light can be obtained even if the ZnO substrate 1 or the AlGaN layer 2 has a high electric resistance. Here, a structure of the semiconductor lamination portion or the like is similar to that of an example shown in Fig. 1, and the same letters and numerals are attached to the same parts and an explanation is omitted.

Fig. 3 is an explanatory cross-sectional view showing a transistor constituted by laminating nitride semiconductor layers with excellent crystallinity by forming the first nitride semiconductor layer 2 made of an AlGaN based compound on a surface of the above described ZnO substrate 1. In a same manner as a case of the light emitting device, the first nitride semiconductor layer 2 is grown at a low temperature of 600 to 800 °C in a MOCVD apparatus by setting a molar ratio of group V element and group III element to 2,000 or less, subsequently necessary organic metal gasses are supplied in a same manner as described above, there are formed, in order, an undoped GaN layer 23 approximately 4 µm thick, an electron transit layer 24 made of an undoped AlGaN based compound approximately 10 nm thick, an n-type GaN layer 25 approximately 5 nm thick, and the electron transit layer 24 is exposed by etching and removing a part of the n-type GaN layer 25 so as to provide a predetermined interval of approximately 1.5µm to be a gate length. And a transistor is constituted by forming a source electrode 26 and a drain electrode 27 made with, for example, a Ti film and a Au film on the n-type GaN layer left with the predetermined interval, and a gate electrode 28 formed by laminating, for example, a Pt film and a Au film on a surface of the undoped AlGaN based compound layer 24. The nitride semiconductor layers with excellent crystallinity can be formed and a transistor (HEMT) with a small leakage current and a high withstand voltage can be obtained, by growing such buffer layer 2 of single crystal on a surface of the substrate and the GaN layer thereon.

As described above, according to the present invention, while using a zinc oxide based compound such as ZnO or the like for a substrate, the first nitride semiconductor layer made of an AlGaN based compound which has a similar lattice constant to that of the substrate, a comparatively small coefficient of thermal expansion, and a property of not transmitting ammonia gas, is provided on a surface of the substrate, and the nitride semiconductor layers are laminated thereon, thereby a nitride semiconductor device with excellent crystallinity can be formed . As a result, there can be significantly improved characteristics of a device using nitride semiconductor such as a nitride semiconductor light emitting device such as a LED, a LD (laser diode) or the like with excellent light emitting characteristics, a nitride transistor such as a HEMT or the like with a small leakage current and a high withstand voltage, or the like.

### INDUSTRIAL APPLICABILITY

Characteristics of a light emitting device using nitride semiconductor, such as a LED or laser diode, and a transistor device such as a HEMT can be improved and the nitride semiconductor device can be used in every kinds of electronic apparatus using the nitride semiconductor device.

## Claims

1. A nitride semiconductor device comprising:
a substrate made of zinc oxide based compound; and
nitride semiconductor layers laminated on the substrate,
wherein the nitride semiconductor layers comprise a first nitride semiconductor layer made of Al_{y}Ga_{1-y}N (0.05 ≦ y ≦ 0.2) provided in contact with the substrate, and nitride semiconductor layers laminated on the first nitride semiconductor layer so as to form a semiconductor element.

2. The nitride semiconductor device according to claim 1, wherein a thickness of the first nitride semiconductor layer is 500 Angstroms or more.

3. The nitride semiconductor device according to claim 2, wherein the thickness of the first nitride semiconductor layer is 2,000 to 8,000 Angstroms.

4. The nitride semiconductor device according to claim 1, wherein a principal plane of the substrate is a (0001) Zn polarity plane.

5. The nitride semiconductor device according to claim 1, wherein the first nitride semiconductor layer is formed so that a surface composition of the first nitride semiconductor layer approaches to that of a nitride semiconductor layer which is provided in contact with the first nitride semiconductor layer as a part of the nitride semiconductor layers.

6. The nitride semiconductor device according to claim 1, wherein an n-type layer, an active layer and a p-type layer are laminated on the first nitride semiconductor layer so as to form a light emitting layer, thereby a semiconductor light emitting device is formed.

7. A method for manufacturing a nitride semiconductor device comprising the steps of:
setting a substrate made of a zinc oxide based compound within a MOCVD apparatus;
growing a first nitride semiconductor layer made of Al_{y}Ga_{1-y}N (0.05≦y≦0.2) at a low temperature of 600 to 800 °C which is lower than that for growing a GaN crystal layer, by supplying raw materials of group III element and group V element with a molar ratio of a raw material of group V element to that of group III element ((group V element)/(group III element)) of 500 or more and 2,000 or less; and
growing desired semiconductor layers subsequently.

8. The method according to claim 7, wherein the step of growing the first nitride semiconductor layer is performed by firstly supplying the raw material of group III element, and thereafter supplying the raw material of group V element.

9. The method according to claim 8, wherein a protection film with a group III element is formed on an exposed surface of the substrate by supplying the raw material of group III element, and thereafter the raw material of group V element is supplied.

10. The method according to claim 7, further comprising the step of forming a protection film, which does not vaporize at a high temperature of 600 °C or more, on an exposed surface except a growth surface of the substrate before growing the first nitride semiconductor layer.
